# EUROPÄISCHE PATENTSCHRIFT

(11) **EP 1 677 167 B1**
(45) Veröffentlichungstag und Bekanntmachung des Hinweises auf die Patenterteilung: **22.05.2013**
(21) Anmeldenummer: 05028719.2
(22) Anmeldetag: 30.12.2005
(51) Int. Cl.: G05B 19/4061, G05B 9/02, H03K 17/945

(54) **Betriebsartenwahlschalter**
Operating modes selector switch
Commutateur de sélection de modes de fonctionnement

(30) Priorität: 03.01.2005 DE 102005000708
(43) Veröffentlichungstag der Anmeldung: 05.07.2006
(73) Patentinhaber: K. A. Schmersal GmbH & Co. KG, 42279 Wuppertal (DE)
(72) Erfinder: Adams, Friedrich, 35435 Wettenberg (DE)
(74) Vertreter: Stoffregen, Hans-Herbert

(56) Entgegenhaltungen:
- EP-A2- 1 363 306
- DE-A1- 10 315 526
- DE-A1- 19 711 588

## Beschreibung

Die Erfindung bezieht sich auf einen Betriebsartenwahlschalter, nach dem Oberbegriff des Anspruchs 1.

Die DE-A-103 15 526 offenbart ein Verfahren und eine Einrichtung zur sicheren Betriebsartenumschaltung einer individuellen Steuerung oder Regelung für Werkzeug- oder Produktionsmaschinen. Dabei ist vorgesehen, dass vor Betriebsartenumschaltung eine Identifikation des Bedieners mittels eines Identifikationsmittels durchgeführt wird, wobei das Identifikationsmittel, bei erfolgreicher Identifikation, ein binäres redundantes Freigabesignal an eine Bedientafel der Steuerung oder Regelung sendet. Die Bedientafel ermöglicht dem Bediener eine Betriebsartenumschaltung mittels in sicherer Technik ausgeführter Tasten der Bedientafel, solange die Bedientafel das Freigabesignal empfängt und keine Störung des Freigabesignals festgestellt wird.

Betriebsartenwahlschalter sind sicherheitsgerichtete Befehlsgeräte an der Mensch-Maschine-Schnittstelle, über die Sonderbetriebsarten von Maschinen aktiviert werden, die im Vergleich zum Normalbetrieb einer Maschine - nachfolgend auch "Automatikbetrieb" genannt - ein erhöhtes Restrisiko für die körperliche Unversehrtheit des Bedieners mit sich bringen.

Im Automatikbetrieb sind alle Sicherheitseinrichtungen einer Maschine aktiv, zum Beispiel ist der Bediener von Gefahr bringenden Bewegungen durch verriegelte bewegliche Schutzeinrichtungen oder durch sicherheitsgerichtete Optoelektronik geschützt. Ein Öffnen der Schutztür oder die Unterbrechung eines Lichtstrahls bewirkt immer einen Maschinenstillstand, d. h. einen für den Bediener sicheren Maschinenzustand. Ein Maschinen-Wiederanlauf setzt voraus, dass die Schutzeinrichtungen wieder in ihrer Schutzstellung sind.

Sonderbetriebsarten sind dagegen dadurch gekennzeichnet, dass Schutzeinrichtungen gezielt (selektiv) überbrückt werden, d. h. die Schutzwirkung wird aufgehoben, damit der Bediener seine Arbeit zweckentsprechend tun kann, jedoch werden im Gegenzug - dieses erhöhte Restrisiko kompensierend - (a) andere sicherheitstechnische Vorkehrungen und Maßnahmen aktiviert und/oder (b) darf nur geschultes und mit den Risiken und den Abläufen de Maschine vertrautes Personal für die jeweilige Sonderbetriebsart eingesetzt werden.

Betriebsartenwahlschalter dienen dabei der Umschaltung vom Automatikbetrieb in die jeweiligen Sonderbetriebsarten.

Sonderbetriebsarten sind erforderlich, damit eine Maschine entsprechend ihrem beabsichtigten Verwendungszweck betrieben werden kann, wenn dazu zum Beispiel auch das Einrichten oder das Beobachten von Prozessen gehört. Gleichgestellt im Sinne dieser Betrachtung sind auch bestimmte Betriebsmodi (mit überbrückten Schutzeinrichtungen) für das Maschinenhersteller- und Inbetriebsetzungs-Personal oder für das Personal, das eine Störung zu beseitigen hat.

Werden an einer Maschine keine Sonderbetriebsarten vorgesehen oder werden sie in einer Art und Weise realisiert, die für den Bediener im Hinblick auf die durchzuführenden Arbeiten nicht zweckdienlich ist, besteht - die Praxis belegt dies - die Gefahr, dass der Bediener an den Schutzeinrichtungen manipuliert, um sie außer Kraft zu setzen. Damit setzt sich der Bediener jedoch einem unkontrollierten Risiko aus, weil für die Maschinensteuerung in diesem Fall der Automatikbetrieb gilt und Vorkehrungen und Maßnahmen, die das Restrisiko in den Sonderbetriebsarten reduzieren (siehe Seite 1) nicht wirksam werden können.

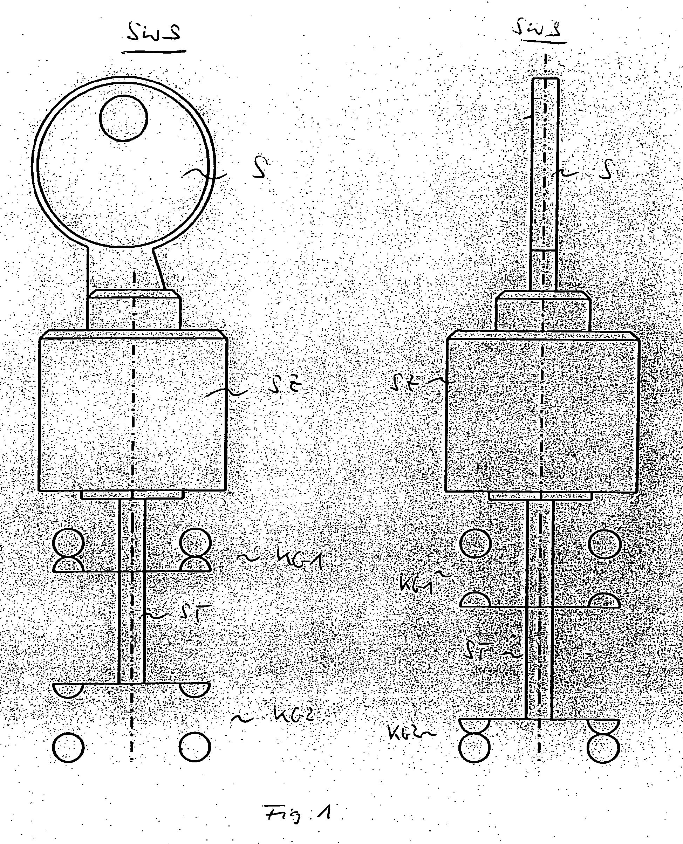

Stand der Technik bei Betriebsartenwahlschaltem sind heute u. a. sogenannte Schlüsselwahlschalter SWS gemäß Fig. 1, die vorzugsweise in der Null-Stellung den Automatikbetrieb einer Maschine freigeben und in der (den) Schaltstellung(en) Sonderbetriebsarten einer Maschine.

Von der Null-Stellung in (eine) Schaltstellung(en) umgeschaltet werden kann nur, wenn ein bestimmter Schlüssel S in den Schlosszylinder SZ eingeführt worden ist und so eine Drehung des Schlosszylinders von der Null-Stellung in die Schaltstellung(en) ermöglicht wird.

Die Drehung im Schlosszylinder SZ bewirkt in diesem Fall die Bewegung eines Stößels ST auf der Bodenseite des Gerätekopfs, die auf (einen oder mehrere) Kontaktgeber KG1, KG2 wirkt und
1. einen in der Nullstellung geschlossenen Kontakt KG1 öffnet und so ein Schaltsignal auslöst, das dazu dient, den Automatikbetrieb einer Maschine sicher zu unterbrechen
   und
(danach) einen in der Nullstellung offenen Kontakt KG2 schließt und so ein zweites Schaltsignal auslöst, das dazu dient, eine Sonderbetriebsart freizugeben.

Die Stößelbewegung (von einem oder mehreren Stößeln) kann dabei auch auf mehrere gleichsinnige Öffner- und Schließer-Kontakte wirken und/oder - je nach Schaltstellung - auch unterschiedliche Schließer-Kontakte schließen.

Das besondere sicherheitstechnische Merkmal eines Schlüsselwahlschalters ist dabei, dass der Öffner-Kontakt KG zwangsweise geöffnet wird, d. h. auch im Fehlerfall (zum Beispiel im Falle eines verschweißten Kontaktes) erfolgt durch die mechanische Stößelbewegung eine Kontaktöffnung mit galvanischer Trennung. Mit anderen Worten ist die Arbeitsweise dieses Kontaktes fehlersicher (fail-safe). Somit kann im Rahmen einer Sicherheitsbetrachtung ausgeschlossen werden, dass in einer Sonderbetriebsart durch einen Fehler oder eine Störung im Schlüsselwahlschalter der für den Bediener gefährliche Automatikbetrieb wirksam bleibt.

Davon ausgehend liegt der Erfindung das Problem zu Grunde einen Betriebsartenwahlschalter der eingangs genannten Art derart weiter zu bilden, dass dieser manipulationssicher ausgebildet und flexibel an Bedienerrechte anpassbar ist.

Das Problem wird erfindungsgemäß durch die Merkmale des Anspruchs 1 gelöst.

Mit der Erfindung wird ein durch ein elektronisches Identifizierungssystem erzeugtes Identifizierungssignal mittels einer nachgeordneten Steuerungselektronik so ausgewertet, dass zunächst ein (oder mehrere) Schaltsignal(e) erzeugt werden, die in ihrer sicherheitstechnischen Qualität einem (oder mehreren) zwangsöffnenden Kontakt(en) entsprechen, die den Automatikbetrieb der Maschinensteuerung unterbrechen, d. h. einen oder mehrere Freigabepfade sicher ausschalten.

Über weitere Befehle, die der Bediener (gleichzeitig oder im Anschluss daran) in einer geeigneten Weise aufruft, würde dann - über andere Freigabepfade - die gewünschte Sonderbetriebsart aktiviert und nach Beendigung der Arbeit - ebenfalls in einer geeigneten Weise - der Automatikbetrieb wieder aufgerufen (freigegeben).

Auch der Aufruf der Sonderbetriebsarten ist nach dieser Lösung in sicherer Technik möglich, was zur Zeit nicht der Fall ist. Zum einen erfüllen Schließer-Kontakte elektromechanischer Kontakte (im Unterschied zu den Öffner-Kontakten) nicht vollumfänglich die Anforderungen an ein fehlersicheres Verhalten, zum anderen ist ein individueller Berechtigungs-basierter Aufruf von Sonderbetriebsarten möglich.

Zur Erhöhung der Sicherheit gegenüber einer Manipulation durch Bedienpersonen ist vorgesehen, dass das Identifizierungssystem ein Eingabesystem wie PIN-System zur Eingabe einer persönlichen Identifikations-Nummer und/oder ein kontaktloses Identifizierungssystem wie Tag (RFID-Tag), kontaktlose Chipkarte, Transponder und/oder ein Biometrie-basiertes System ist.

In dem Identifizierungssystem sind Identifizierungsdaten von Bedienern oder Bedienergruppen speicherbar. Dadurch ist ein individueller berechtigungsbasierter Aufruf von Sonderbetriebsarten möglich.

Des Weiteren zeichnet sich der Betriebsartenwahlschalter dadurch aus, dass in dem Identifizierungssystem für Bediener oder Bedienergruppen individuell zusätzliche Sonderbetriebsarten definierbar sind.

Die Steuerungselektronik - wahlweise ein elektronisches oder programmierbar elektronisches System mit Sicherheitsfunktion - wird zu diesem Zweck so ausgeführt, dass hier (in der Steuerungselektronik, beginnend mit der Signalerfassung der Identifizierung über die Logik bis hin zur Signalausgabe) Fehler (und auch Folgefehler davon) durch fehlerbeherrschende und/oder fehlertolerierende Maßnahmen nicht zu einem Verlust der Personenschutzfunktion (der Sicherheitsfunktion) führen würden und zudem durch fehleraufdeckende Maßnahmen auch Fehlerakkumulationen wirksam verhindert werden.

Gemäß einer weiteren bevorzugten Ausführungsform ist die Steuerungselektronik zweikanalig ausgebildet, wobei jeder Kanal ein Mikrocomputer-System aufweist, welches eingangsseitig mit der Identifizierungssystem verbunden ist, wobei zumindest eines der Mikrocomputer-Systeme ausgangsseitig mit zumindest einem Ausgang einer Ausgangsebene zum Schalten zumindest des Freigabepfades für den Automatikbetrieb und mit zumindest einem weiteren Ausgang zum Schalten zumindest des weiteren Freigabepfades für die zumindest eine Sonderbetriebsart verbunden ist und dass zumindest eines der Mikrocomputer-Systeme mit Eingängen einer Eingangsebene verbunden ist, an denen Signale für Zusatzbedingungen anschließbar sind.

Hierbei ist vorgesehen, dass die Mikrocomputer-Systeme über eine Datenleitung zum gemeinsamen Datenvergleich gekoppelt sind.

Diese bevorzugte Ausführungsform für die Sicherheitselektronik ist dabei eine Doppelanordnung von zwei - voneinander unabhängigen - Mikrocomputer-Systemen, die sich - unter Einschluss ihrer vor- und nachgelagerten Peripherie - fortlaufend kreuzweise vergleichen. Hinzu kämen alle übrigen bekannten sicherheitstechnischen Maßnahmen, wie sie bei elektronischen oder programmierbar elektronischen System mit Sicherheitsfunktion angewendet werden (siehe hierzu auch IEC 61508).

Je nach sicherheitstechnischer Qualität des erzeugten Identifizierungssignals kommen auch für dieses Teil-System zusätzliche sicherheitsgerichtete Maßnahmen in Frage, z. B. eine (wahlweise invertierte) Doppeleingabe der Identifizierung, eine sicherheitsgerichtete serielle oder parallele Datenübertragung der Identifizierungsdaten etc.. Dies um auch in diesem Teil-System wiederum sicherzustellen, dass Fehler (und auch Folgefehler davon) durch fehlerbeherrschende und/oder fehlertolerierende Maßnahmen nicht zu einem Verlust der Personenschutzfunktion (der Sicherheitsfunktion) des Betriebsartenwahlschalters führen würden und zudem durch fehleraufdeckende Maßnahmen auch Fehlerakkumulationen wirksam verhindert werden.

Würde man einen Betriebsartenwahlschalter nun - statt eines Schlüsselwahlschalters - mit einem PIN-, einem Tag- oder einen Biometrie-basierten System realisieren, hätte dies zwar mehrere Vorteile, jedoch entfiele der elementare sicherheitstechnische Vorteil der Unterbrechung des Automatikbetriebs per Zwangsöffnung und galvanischer Trennung eines elektromechanischen Kontaktsystems mit zwangsöffnenden Öffner-Kontakten. D. h. durch Störung oder einen Fehlerfall könnte der Automatikbetrieb einer Maschinensteuerung weiterhin aktiviert bleiben oder unvorhergesehen aktiviert werden. In beiden Fehlerfällen könnte der Bediener einer großen Gefahr ausgesetzt sein.

Insofern scheiden aus sicherheitstechnischen Gründen handelsübliche PIN-, Tag- oder Biometrie-basierte Systeme als Schlüsselwahlschalter-Substitut aus, wenngleich es zahlreiche Vorteile im Vergleich zum traditionellen Stand der Technik gäbe.

Zum einen ist es heute relativ leicht möglich, dass auch ungeschulte Bediener in einer sie selbst gefährdenden Art und Weise mit Sonderbetriebsarten herum hantieren, weil der Schlüssel im Schlüsselwahlschalter (Betriebsartenwahlschalter) während des Maschinenbetriebs vorschriftswidrig steckt. Richtig wäre es hingegen, wenn der Schlüssel - wenn er nicht gebraucht wird - in der Obhut einer verantwortlichen Aufsichtsperson wäre. Bei dem neuartigen (den Gegenstand dieser Erfindung bildenden) Betriebsartenwahlschalter hätten hingegen nur ausgewählte Bediener Zugriff, weil deren Identifizierung per PIN-, Tag- oder Biometrie-basiertem System vorher "geteacht" worden wäre.

Man könnte darüber hinaus die Berechtigung zu Sonderbetriebsarten Bediener- oder Bedienergruppen-individuell ausgestalten oder umgekehrt Bediener- oder Bedienergruppen-individuell zusätzliche Sonderbetriebsarten kreieren.

Alle diese Möglichkeiten dienen auf der einen Seite einem zweckdienlicheren Maschinenbetrieb und damit einer Erhöhung der Wirtschaftlichkeit, zum anderen aber auch einem höheren Maß an Bedienersicherheit und damit dem Arbeitsschutz, weil weniger Manipulationen zu erwarten wären und zugleich sichergestellt ist, dass nur entsprechend autorisiertes, d. h. geschultes und mit seinem Tun vertrautes Personal Zugriff zu Sonderbetriebsarten hätte.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines der Zeichnung zu entnehmenden Ausführungsbeispiels.

### Es zeigen:

- Fig. 1: einen Betriebsartenwahlschalter nach dem Stand der Technik,
- Fig. 2: einen erfindungsgemäßen Betriebsartenwahlschalter.

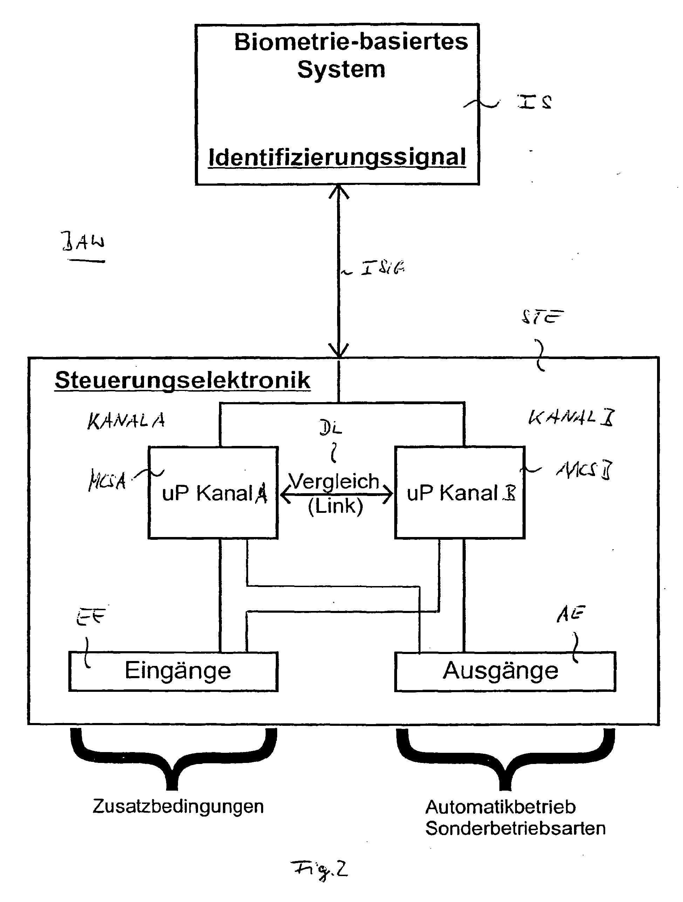

Fig. 2 zeigt ein Blockschaltbild eines Betriebsartenwahlschalters BAW, umfassend ein Identifizierungssystem IS, welches mit einer Steuerungselektronik STE verbunden ist.

Das Identifizierungssystem basiert auf einem Eingabesystem wie PIN-, kontaktlosem Identifizierungssystem wie TAG- und/oder Biometrie-System und erzeugt, entsprechend den von einer Bedienperson eingegebenen Daten bzw. den biometrischen Eigenschaften der Bedienperson ein Identifizierungssignal ISIG, welches in der Steuerungselektronik STE ausgewertet wird. Die Steuerungselektronik ist vorzugsweise zweikanalig ausgebildet, umfassend einen ersten Kanal A sowie einen zweiten Kanal B, wobei jeder Kanal A, B ein Mikrocomputersystem MCSA, MCSB aufweist, die über eine Datenleitung DL miteinander gekoppelt sind, um einen kreuzweisen Datenvergleich durchführen zu können. Eingangsseitig sind die Mikrocomputersysteme MCSA, MCSB mit dem Identifizierungssystem verbunden, so dass diesen das Identifizierungssignal zur weiteren Verarbeitung zugeführt wird.

Ausgänge der Mikrocomputersysteme MCS, MCSA sind mit einer Ausgangsebene AE verbunden, über die Freigabepfade, d. h. elektrische Kontakte, ansteuerbar sind. Eingänge der Mikrocomputersysteme MCSA, MCSB sind mit einer Eingangsebene EE verbunden, um beispielsweise Zusatzbedingungen zu erfassen. Die Ausgangsebene AE kann sowohl vom Mikrocomputersystem MCSA als auch vom Mikrocomputersystem MCSB angesteuert werden. Gleiches gilt für die Verarbeitung von an der Eingangsebene EE anliegender Signale.

Das durch das Identifizierungssystem IS beispielsweise auf der Basis eines PIN-, TAG- oder Biometrie-Systems erzeugte Identifzierungssignal ISIG wird in der Steuerungselektronik STE durch die Mikrocomputersysteme MCSA, MCSB derart ausgewertet, dass zunächst ein (oder mehrere) Schaltsignal(e) erzeugt werden, die in ihrer sicherheitstechnischen Qualität einem (oder mehreren) zwangsöffnenden Kontakt(en) entsprechen, die den Automatikbetrieb der Maschinensteuerung unterbrechen, d. h. einen oder mehrere Freigabepfade sicher ausschalten.

Über weitere Befehle, die der Bediener (gleichzeitig oder im Anschluss daran) in einer geeigneten Weise aufruft, wird dann - über andere Freigabepfade - die gewünschte Sonderbetriebsart aktiviert und nach Beendigung der Arbeit - ebenfalls in geeignet Weise - der Automatikbetrieb wieder aufgerufen, d. h. freigegeben.

## Patentansprüche

1. Betriebsartenwahlschalter umfassend eine über eine Zugangsberechtigungseinheit (IS) aktivierbare Schalteinheit (STE) mit der eine Maschine aus einem Automatikbetrieb, in dem Sicherheitseinrichtungen der Maschine aktiv sind, in zumindest eine Sonderbetriebsart, in der die im Automatikbetrieb wirksamen Sicherheitseinrichtungen ganz oder teilweise überbrückt sind, umschaltbar und aus der zumindest einen Sonderbetriebsart zurück in den Automatikbetrieb schaltbar ist, **wobei die Zugangsberechtigungseinheit (IS) als elektronisches Identifizierungssystem (IS) ausgebildet ist, das ein Identifizierungssignal (ISIG) als ersten Befehl erzeugt,**
**dadurch gekennzeichnet,**
**dass** der erste Befehl der Schalteinheit (STE) bewirkt, dass zumindest ein in seiner sicherheitstechnischen Qualität einem zwangsöffnenden Kontakt entsprechendes Schaltsignal zur Unterbrechung des Automatikbetriebs der Maschine mittels eines ersten Freigabepfades generierbar ist, **dass in dem Identifizierungssystem (IS) Identifizierungsdaten von Bedienern oder Bedienergruppen gespeichert sind, wobei für Bediener oder Bedienergruppen individuell zumindest eine individuelle Sonderbetriebsart definierbar ist, und dass über zumindest einen weiteren Befehl, gleichzeitig oder im Anschluss an den ersten Befehl, die zumindest eine individuelle Sonderbetriebsart über zumindest einen weiteren Freigabepfad aktivierbar ist.**

2. Betriebsartenwahlschalter nach Anspruch 1 oder 2,
**dadurch gekennzeichnet,**
**dass** das Identifizierungssystem (IS) ein Eingabesystem wie PIN-System zur Eingabe einer persönlichen Identifikationsnummer, ein kontaktloses Identifizierungssystem wie TAG-(RFID-Tag), kontaktlose Chipkarte, Transponder und/oder ein Biometrie-basiertes System ist.

3. Betriebsartenwahlschalter nach zumindest einem der vorhergehenden Ansprüche,
**dadurch gekennzeichnet,**
**dass** die Steuereinheit (STE) als Steuerelektronik vorzugsweise als elektronisches oder programmierbares elektronisches System mit Sicherheitsfunktion ausgebildet ist.

4. Betriebsartenwahlschalter nach zumindest einem der vorhergehenden Ansprüche,
**dadurch gekennzeichnet,**
**dass** die Steuerungselektronik (STE) zweikanalig ausgebildet ist, wobei jeder Kanal (A, B) ein Mikrocomputer-System (MCSA, MCSAB) aufweist, welches eingangsseitig mit der Identifizierungseinheit (IS) verbunden ist, wobei zumindest eines der Mikrocomputer-Systeme (MCSA, MCSB) ausgangseitig mit zumindest einem Ausgang einer Ausgangebene (AE) zum Schalten zumindest des Freigabepfades für den Automatikbetrieb und mit zumindest einem weiteren Ausgang der Ausgangsebene (AE) zum Schalten zumindest des weiteren Freigabepfades für die zumindest eine Sonderbetriebsart verbunden ist und dass zumindest eines der Mikrocomputer-Systeme (MCSA, MCSB) mit Eingängen einer Eingangsebene (EE) verbunden ist, an denen Signale für Zusatzbedingungen anschließbar sind.

5. Betriebsartenwahlschalter nach zumindest einem der vorhergehenden Ansprüche,
**dadurch gekennzeichnet,**
**dass** die Mikrocomputersysteme (MCSA, MCSB) über eine Datenleitung (DL) zum gemeinsamen Datenvergleich gekoppelt sind.

6. Betriebsartenwahlschalter nach zumindest einem der vorhergehenden Ansprüche,
**dadurch gekennzeichnet,**
**dass** die Steuerungselektronik (STE) und/oder das Identifikationssystem (IS) Mittel zur Durchführung von fehlerbeherrschenden und/oder fehlertolerierenden Maßnahmen aufweist und dass in der Steuerungselektronik (STE) ein Test des Identifizierungssystems (IS) durchführbar ist.

7. Betriebsartenwahlschalter nach zumindest einem der vorhergehenden Ansprüche,
**dadurch gekennzeichnet,**
**dass** das Identifizierungssystem (IS) Mittel zur wahlweise invertierten Doppeleingabe der Identifizierung aufweist.

8. Betriebsartenwahlschalter nach zumindest einem der vorhergehenden Ansprüche,
**dadurch gekennzeichnet,**
**dass** das Identifizierungssystem (IS) Mittel zur sicherheitsgerichteten seriellen oder parallelen Datenübertragung der Identifizierungsdaten aufweist.

## Claims

1. Mode selector switch comprising a switching unit (STE) activatable by an access authorization unit (IS) and using which a machine can be switched over from an automatic mode in which security devices of the machine are active into at least one special mode in which the security devices effective in automatic mode are completely or partially jumpered, and switched back from the at least one special mode into the automatic mode, the access authorization unit (IS) being designed as an electronic identification system (IS) that generates an identification signal (ISIG) as a first command,
**wherein**
the first command of the switching unit (STE) has the effect that at least one switching signal with a security-related quality matching a positively opening contact can be generated for interruption of the automatic mode of the machine by means of a first enabling path, wherein identification data of operators and operator groups is saved in the identification system (IS), with at least one individual special mode being definable for operators or operator groups, and wherein the at least one individual special mode can be activated by at least one further enabling path with at least one further command simultaneous or consecutive to the first command.

2. Mode selector switch according to Claim 1,
**wherein**
the identification system (IS) is an input system such as a PIN system for input of a personal identification number, a contactless identification system such as TAG (RFID tag), a contactless chipcard, a transponder and/or a biometry-based system.

3. Mode selector switch according to at least one of the preceding claims,
**wherein**
the control unit (STE) is designed as an electronic control unit, preferably as an electronic or programmable electronic system with security function.

4. Mode selector switch according to at least one of the preceding claims,
**wherein**
the electronic control unit (STE) is designed with two channels, each channel (A, B) having a microcomputer system (MCSA, MCSB) which is connected on the input side to the identification system (IS), each of said microcomputer systems (MCSA, MCSB) being connected on the output side to at least one output of an output plane (AE) for switching of at least the enabling path for the automatic mode and to at least one further output of the output plane (AE) for switching of at least the further enabling path for the at least one special mode, and wherein at least one of the microcomputer systems (MCSA, MCSB) is connected to inputs of an input plane (EE) to which signals for additional conditions can be connected.

5. Mode selector switch according to at least one of the preceding claims,
**wherein**
the microcomputer systems (MCSA, MCSB) are connected via a data line (DL) for a joint data comparison.

6. Mode selector switch according to at least one of the preceding claims,
**wherein**
the electronic control unit (STE) and/or the identification system (IS) has means for implementation of error-controlling and/or error-tolerating measures and wherein a test of the identification system (IS) can be conducted in the electronic control unit (STE).

7. Mode selector switch according to at least one of the preceding claims,
**wherein**
the identification system (IS) has means for optional inverted double input of the identification.

8. Mode selector switch according to at least one of the preceding claims,
**wherein**
the identification system (IS) has means for security-oriented serial or parallel data transmission of the identification data.

## Revendications

1. Sélecteur de modes de service, comprenant une boîte de commutation (STE) activable par l'intermédiaire d'une unité de droit d'accès (IS) et avec laquelle une machine peut être commutée d'un mode automatique, dans lequel des dispositifs de sécurité de la machine sont activés, à au moins un mode de service spécial, dans lequel les dispositifs de sécurité actifs en mode automatique sont pontés en tout ou en partie, et avec laquelle la machine peut être de nouveau recommutée de l'au moins un mode de service spécial au mode automatique, l'unité de droit d'accès (IS) étant conçue sous forme de système d'identification électronique (IS) qui génère un signal d'identification (ISIG) en tant que première instruction,
**caractérisé en ce**
**que** la première instruction de la boîte de commutation (STE) a pour effet qu'au moins un signal de commutation, dont la qualité en matière de sécurité correspond à un contact à ouverture forcée, peut être généré afin d'interrompre le mode automatique de la machine via un premier chemin de validation, que dans le système d'identification (IS) sont enregistrées des données d'identification d'utilisateurs ou de groupes d'utilisateurs, définissant individuellement au moins un mode de service spécial personnalisé pour lesdits utilisateurs ou groupes d'utilisateurs, et que l'au moins un mode de service spécial peut être activé via au moins un autre chemin de validation à l'aide d'au moins une instruction supplémentaire donnée simultanément ou consécutivement à la première instruction.

2. Sélecteur de modes de service selon la revendication 1,
**caractérisé en ce**
**que** le système d'identification (IS) est un système de saisie tel qu'un système PIN pour saisir un numéro d'identification personnel, un système d'identification sans contact tel que TAG (tag RFID), une carte à puce sans contact, un transpondeur et/ou un système basé sur la biométrie.

3. Sélecteur de modes de service selon au moins une des revendications précédentes,
**caractérisé en ce**
**que** l'unité de commande (STE) est conçue en tant qu'organe électronique de commande, de préférence en tant que système électronique ou programmable, avec fonction de sécurité.

4. Sélecteur de modes de service selon au moins une des revendications précédentes,
**caractérisé en ce**
**que** l'unité de commande électronique (STE) est conçue à deux voies, sachant que chaque voie (A, B) dispose d'un système à microordinateur (MCSA, MCSAB) relié au niveau entrée à l'unité d'identification (IS), qu'au moins un des systèmes à microordinateur (MCSA, MCSB) est relié au niveau sortie à au moins une sortie d'un niveau de sortie (AE) afin de commuter au moins le chemin de validation pour le mode automatique, et à au moins une autre sortie du niveau de sortie (AE) afin de commuter au moins l'autre chemin de validation pour l'au moins un mode de service spécial, et qu'au moins un des systèmes à microordinateur (MCSA, MCSB) est relié à des entrées d'un niveau d'entrée (EE) auxquelles peuvent être connectés des signaux pour des conditions supplémentaires.

5. Sélecteur de modes de service selon au moins une des revendications précédentes,
**caractérisé en ce**
**que** les systèmes à microordinateur (MCSA, MCSB) sont couplés par une ligne de transmission de données (DL) pour une comparaison conjointe des données.

6. Sélecteur de modes de service selon au moins une des revendications précédentes,
**caractérisé en ce**
**que** l'unité de commande électronique (STE) et/ou le système d'identification (IS) présente(nt) des moyens d'exécution de mesures maîtrisant et/ou tolérant des erreurs, et qu'un test du système d'identification (IS) est exécutable dans l'unité de commande électronique (STE).

7. Sélecteur de modes de service selon au moins une des revendications précédentes,
**caractérisé en ce**
**que** le système d'identification (IS) présente des moyens pour une double saisie inversée optionnelle de l'identifiant.

8. Sélecteur de modes de service selon au moins une des revendications précédentes,
**caractérisé en ce**
**que** le système d'identification (IS) présente des moyens axés sur la sécurité pour la transmission en série ou en parallèle des données d'identification.
